Europäisches Patentamt

European Patent Office

Office européen des brevets

(11) Veröffentlichungsnummer: **0 253 015**
**A1**

## (12) EUROPÄISCHE PATENTANMELDUNG

(21) Anmeldenummer: **86109907.5**

(22) Anmeldetag: **18.07.86**

(51) Int. Cl.⁴: **B07C 5/344** , G01R 31/28

(43) Veröffentlichungstag der Anmeldung:
**20.01.88 Patentblatt 88/03**

(84) Benannte Vertragsstaaten:
**AT CH DE FR GB IT LI NL SE**

(71) Anmelder: **SCHOENELEC**
**Produktionseinrichtungen für die**
**Elektronikindustrie GmbH**
**Schleissheimerstrasse 22-24**
**D-8000 München 2(DE)**

(72) Erfinder: **Gerganoff, Konstantin**
**Stiftsbogen 154**
**D-8000 München 70(DE)**

(74) Vertreter: **Schütz, Peter, Dipl.-Ing. et al**
**Patentanwälte Dr. Dieter v. Bezold Dipl.-Ing.**
**Peter Schütz Dipl.-Ing. Wolfgang Heusler**
**Maria-Theresia-Strasse 22 Postfach 86 02 60**
**D-8000 München 86(DE)**

(54) **Transportsystem für eine Prüfeinrichtung für elektronische Bauelemente.**

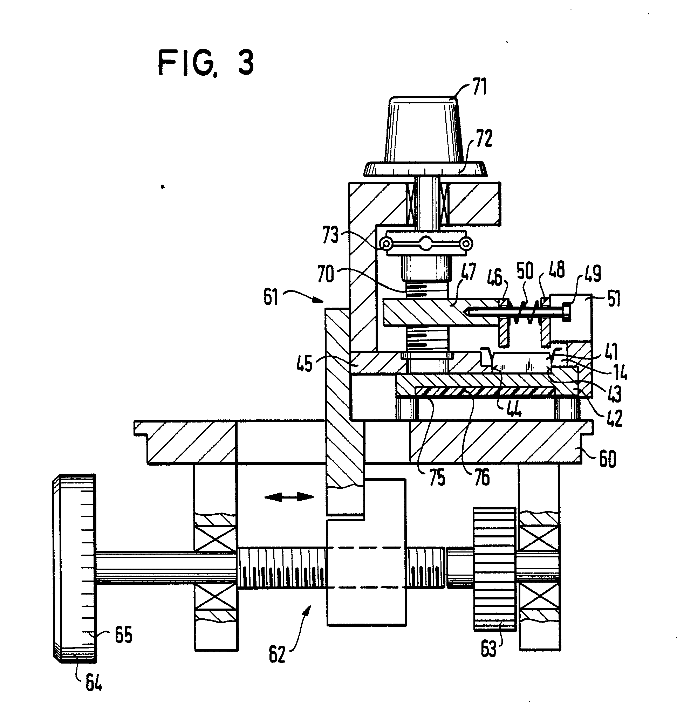

(57) Ein Transportsystem einer Prüfeinrichtung für elektronische Bauelemente (41) läßt sich ohne Auswechseln von Teilen auf unterschiedliche Bauelementgrößen genau einstellen. Mittels verstellbarer Schienen werden Länge und Breite des Querschnitts der Transportstrecken über Spindeltriebe mikrometergenau eingestellt. Ein Magazinkopf (40) mit mehreren ebenfalls einstellbaren Magazineinstecköffnungen (42) ist gegenüber einem Zuführschacht (36) für den Bauelementetransport zur Prüfstation (26) verschiebbar zur Ausrichtung der einzelnen zueinander parallelen Einstecköffnungen (42) mit dem Zuführschacht (14), in den die Bauelemente (41) hineinrutschen. Nach der Prüfung rutschen die Bauelemente (41) einzeln in einen Verteiler (17) mit einer quer verschiebbaren Weiche zur Verteilung der Bauelemente je nach Prüfergebnis in Ausgangsschächte (18). Diese liegen ebenfalls parallel nebeneinander und haben einen gemeinsamen Verstellmechanismus für ihre Schienen zur Querschnittseinstellung. Die Schienen von Führungsschacht und Ausgangsschächten werden wie die Weiche genau reproduzierbar über Spindeltriebe (62a, 70a) verstellt. Von Eingabe bis Ausgabe durchlaufen die Bauelemente (41) eine lineare Transportstrecke ohne Umlenkung außer der Weichenverschiebung. Die Neigung dieser Linearstrecke ist einstellbar auf den für unterschiedliche Bauelementtypen günstigsten Rutschwinkel (Fig. 3).

FIG. 1

# FIG. 3

1a.

## Transportsystem für eine Prüfeinrichtung für elektronische Bauelemente

Die Erfindung betrifft eine Prüfeinrichtung für elektronische Bauelemente, wie sie im Oberbegriff des Anspruchs 1 vorausgesetzt ist.

Vor der Fertigung elektronischer Geräte werden die verwendeten Bauelemente üblicherweise einer Eingangskontrolle unterzogen, um sicherzustellen, daß nur einwandfreie Bauelemente in der Fertigung verwendet werden. Da die verschiedenen Bauelemente, wie z.B. integrierte Schaltungen, sehr verschiedene Abmessungen haben, müssen die Prüfgeräte für unterschiedliche Typen jeweils umgerüstet werden. Gleiche Bauelemente werden in Magazinen angeliefert, deren Dimensionen den Abmessungen der jeweiligen Bauelemente entsprechen und aus denen die Bauelemente in einen Zuführschacht der Prüfeinrichtung überführt werden müssen. Für Bauelemente unterschiedlicher Abmessungen (kleine und große SO-IC's, VSO-IC's, LCC-IC's, PLCC-IC's, PINGRID-IC's, um die häufigsten Arten zu nennen), mußten bisher die Führungsteile des Prüfgerätes entsprechend ausgewechselt und jeweils justiert werden, was aufwendig und zeitraubend ist. Zwar ist es bekannt, die Breite der Führungsschienen in einem kleinen Bereich verstellbar zu machen, jedoch benötigt man dazu Werkzeug und Meßeinrichtungen für die genaue Justierung und Fixierung. Außerdem sind bei jeder größeren Toleranzabweichung (beispielsweise 0,2 bis 0,3 mm) Neujustierungen erforderlich. Für LCC-und PLCC-IC's gibt es sogenannte Führungskäfige, die im Eingabebereich, im Kontaktierbereich, Sortierbereich und Ausgabebereich ausgewechselt werden müssen und ebenfalls eine relativ aufwendige Justage erfordern. Diese Geräte eignen sich wiederum nicht für PINGRID-IC's, SO-IC's und VSO-IC's.

Hinzu kommt, daß gleiche Bauelemente von verschiedenen Herstellern recht unterschiedliche Toleranzen haben und auch daher häufig zeitraubende Justagen erforderlich werden. Ein weiteres Problem besteht durch die verschiedenen Gewichte unterschiedlicher Bauelemente, die dadurch mit unterschiedlichen Geschwindigkeiten in den schrägen Führungskanälen rutschen. Wenn die leichteren Bauelemente mit Plastikgehäusen noch einigermaßen sicher weiterrutschen sollen, dann rutschen die schwereren Bauelemente mit Keramikgehäusen bereits zu schnell, so daß beim Anschlagen Sprünge oder Haarrisse im Gehäuse auftreten können. Wählt man dagegen die Neigung der Führungsteile für diese Bauelemente geeigneter, dann rutschen die leichteren Bauelemente nicht mehr richtig. In der Praxis führen diese Schwierigkeiten und die zeitraubenden Auswechsel-und Justierarbeiten dazu, daß man für unterschiedliche Bauelemente verschiedene Prüfeinrichtungen verwendet und die hohen Kosten dafür in Kauf nimmt.

Die Aufgabe der Erfindung besteht in der Schaffung einer Prüfeinrichtung, die kein Auswechseln von Teilen für die Prüfung von Bauelementen unterschiedlicher Abmessungen erfordert, sich einfach und schnell auf unterschiedliche Toleranzen einstellen läßt und einen problemlosen Durchlauf der Bauelemente vom Eingabemazagin bis zum Ausgabemagazin gewährleistet.

Diese Aufgabe wird durch die im Kennzeichenteil des Anspruchs 1 angegebenen Merkmale gelöst.

Durch die Einstellbarkeit sämtlicher Führungsteile in beiden Dimensionen ihres Querschnittes über den gesamten Bereich praktisch vorkommender Abmessungen der Bauelemente kann ein und dieselbe Prüfeinrichtung zur Prüfung aller Bauelemente verwendet werden. Diese Einstellung erfolgt vorzugsweise über Handräder und Spindeltriebe ähnlich wie ein Mikrometer, so daß sehr genaue Einstellungen auf unterschiedliche Abmessungen und Toleranzen schnell und einfach möglich sind. Dazu dient auch die Adaptierbarkeit der Einstecköffnungen des Magazinkopfes an unterschiedliche Magazinabmessungen, die bei einer zweckmäßigen Ausgestaltung der Erfindung durch eine Andruckfeder, die unterschiedliche Magazinstärken ausgleicht, und einen ebenfalls federbelasteten Schieber, der unterschiedliche Magazinbreiten ausgleicht, realisiert wird.

Zweckmäßigerweise sind ferner die Einstecköffnungen für die Magazine im Magazinkopf raumsparend so angeordnet, daß ihre Querschnittslängsseiten parallel nebeneinander liegen und die Schieber alle von einer Seite über Zuggriffe bedient werden können. Dadurch läßt sich bei bequemer Bedienung der Magazinkopf kompakt gestalten und damit das gesamte Gerät - schmaler bauen.

Um die Bauelemente möglichst bei ihrer Betriebstemperatur prüfen zu können, ist zweckmäßigerweise über die gesamte Länge des Zuführschachtes und in der Prüfstation selbst eine Heizvorrichtung, vorzugsweise in Form einer Heizfolie, angeordnet, durch welche die Bauelemente während ihres Durchlaufs durch den Führungsschacht und in der Prüfstation selbst erwärmt werden bzw. bleiben.

Während ihres Durchlaufs durch das Gerät rutschen die Bauelemente mit nach oben gerichteten Anschlußkontakten längs einer auf ihr jeweiliges Gewicht leicht und einfach einstellbaren Schräge entlang eines linearen Weges. In dieser Lage können sie in der Prüfstation auch problemlos durch einen Testkopf kontaktiert werden, dessen Andruckkraft günstigerweise einstellbar ist, gemäß einer zweckmäßigen Ausführungsform der Erfindung über den Erregerstrom eines Elektromagneten, dessen Anker in spezieller Ausgestaltung der Erfindung den Testkopf über einen Winkelhebel bewegen kann. Die Einstellbarkeit der Andruckkraft ist insofern von Bedeutung, als unterschiedliche Bauelemente eine sehr verschiedene Anzahl von Kontaktflächen haben können, die bei der Prüfung sämtlich mit einer bestimmten Kontaktfraft kontaktiert werden sollen, so daß die auf den Kontaktkopf ausgeübte Andruckkraft sich bei einer großen Kontaktzahl auf mehr Kontakte als bei einer kleinen Kontaktzahl verteilt und die auf den Testkopf ausgeübte Andruckkraft daher entsprechend größer sein muß. Die Andruckkraft läßt sich über das Programm eines Mikroprozessors steuern, der auch den gesamten Prüfungsablauf bestimmt.

Der einfachen Austauschbarkeit der Testköpfe kann auch eine Steckerverbindung dienen, über welche die einzelnen federnden Kontaktstifte des Testkopfes mit einer festen Kontaktleiste verbunden werden können, an welche die bewegliche Prüfeinheit dann herangefahren werden kann. Der Testkopf selbst mit den Prüfspitzen kann an der verschiebbaren Halterung angeschraubt sein und läßt sich somit leicht auswechseln. Unter dem Testkopf mit der Kontaktsatzhalterung kann zweckmäßigerweise eine kleine Mikrometerschraube angebracht sein, die eine genaue Einstellung der Prüfspitzen zu den Kontakten des Bauelementes erlaubt, falls dies erforderlich ist.

Um ein Anhaften der Bauelemente in der Prüfstation und nach der Prüfung in der Weiche des Verteilers zu verhindern, können zweckmäßigerweise die jeweiligen Auflageflächen für die Bauelemente mit Rillen ausgebildet sein, so daß die Berührungsfläche der Bauelemente mit den betreffenden Auflageflächen und damit die Gefahr eines Haftens geringer wird.

Die Weiche des Verteilers kann zweckmäßigerweise einen Schlitten mit einem Kanal aufweisen, in welchen die Bauelemente nach der Prüfung hineingleiten und der ebenfalls in seinen Abmessungen auf den geprüften Bauelementtyp einstellbar ist, wozu ein gleicher Einstellmechanismus wie für den Zuführungsschacht dienen kann. Dieser Schlitten kann gemäß einer speziellen Ausführungsform der Erfindung quer zur Richtung des Zuführungsschachtes verschiebbar sein, um ein geprüftes Bauelement zu einem Ausgangsschacht zu bringen, der entsprechend dem Ergebnis der Prüfung des betreffenden Bauelementes auswählbar ist, wobei die Ausrichtung des Kanals des Schiebers mit dem Ausgangsschacht sich zweckmäßigerweise mit Hilfe einer Lichtschranke und einer Blende steuern lassen kann.

Die Ausgangsschächte sind erfindungsgemäß wiederum ebenso raumsparend parallel zueinander wie die Einstecköffnungen des Magazinkopfes angeordnet und in ihrem Querschnitt einstellbar, wozu der gleiche Mechanismus mit Einstellrädern, Spindeltrieb und Parallelführung wie für den Zuführschacht dienen kann. Eine spezielle Ausgestaltung der hierbei verstellbaren Schienen besteht erfindungsgemäß darin, daß ebenso wie beim Zuführschacht diejenige Schiene, welche die zwischen den Kontakten befindliche Fläche der Bauelemente führt, in zwei parallel gegeneinander bewegliche Teilschienen unterteilt ist, deren mit dem Bauelement zusammenwirkenden Teilflächen bei den kleinsten Bauelementen zusammenliegen, bei größeren Bauelementen dagegen soweit auseinander wandern, daß die Bauelemente auf dieser Seite doppelt und somit sicherer geführt werden.

Damit die geprüften Bauelemente aus den Ausgangsschächten nicht herausfallen, sind an deren Enden Anschläge vorge sehen, die gemäß einer weiteren Ausgestaltung der Erfindung nasenförmig mit einer nach unten weisenden Schrägfläche ausgebildet sind, mit Hilfe deren die Vorderkante eines Ausgabemagazins beim Einschieben den Anschlag zur Seite drückt, so daß die geprüften Bauelemente aus dem Ausgabeschacht von selbst in das Magazin hineinrutschen. Mit der Einstellung der Abmessungen der Ausgangsschächte werden diese zugleich auf den Querschnitt der Ausgabemagazine eingestellt, so daß die passenden Magazine ohne weiteres eingeschoben werden können.

Die Verstellmechanismen für sämtliche Ausgangsschächte sind zweckmäßigerweise miteinander gekoppelt, so daß mit jeweils einem Einstellrad für jede Querschnittsdimension (Breite und Dicke) sämtliche Ausgangsschächte gleichzeitig verstellbar sind. Die Koppelung der entsprechenden Spindeltriebe kann auch hier über Ketten oder Zahnriemen erfolgen. Der Verstellmechanismus für die Abmessungen der Schächte kann hochpräzise Kugelumlaufführungen und Linearlager aufweisen, so daß eine präzise Einstellung über einen relativ großen Einstellbereich, wie er von den kleinsten bis zu den größten Bauelementen benötigt wird, mit Mikrometergenauigkeit garantiert ist. Als Beispiel für die Breiteneinstellung der Schächte sei ein Bereich von 3,5 mm bis 75 mm angegeben, während für die Dicke ein Bereich bis 10 mm genügt. Die jeweiligen Abmessungen lassen sich ohne weiteres auf Zehntelmillimeter-Genauigkeit einstellen und an den Einstellrädern ablesen. Dies gilt sowohl für den Zuführschacht wie auch für den Kanal des Weichenschlittens und die Ausgangsschächte.

Da die Bauelemente durch das ganze Gerät in linearer Bewegung (mit Ausnahme der Parallelverschiebung im Verteiler) ohne Umlenkung hindurchlaufen und die Querschnitte der Führungen sich sehr genau einstellen lassen, besteht praktisch keine Gefahr eines Hängenbleibens von Bauelementen. Außerdem läßt sich der Neigungswinkel dieser Linear strecke entsprechend Größe und Gewicht unterschiedlicher Bauelemente jeweils so einstellen, daß die Rutschgeschwindigkeit der durch ihr Eigengewicht durch das Gerät transportierten Bauelemente individuell auf den günstigsten Wert eingestellt werden kann, so daß Beschädigungen von beispielsweise Keramikelementen ausgeschlossen werden können. Diese Winkeleinstellung erfolgt in einfacher Weise mittels eines Einstellgelenkes, über das die gesamte lineare Anordnung mit einem Grundgestell verbunden ist.

Die Erfindung wird nachfolgend anhand eines in den beiliegenden Zeichnungen veranschaulichten Ausführungsbeispiels im einzelnen erläutert. Es zeigen.

Fig. 1 eine Seitenansicht des gesamten Transportsystems einschließlich Grundgestell;

Fig. 2 eine Draufsicht auf den Magazinkopf;

Fig. 3 eine Schnittansicht der Einstellvorrichtung für die Querschnittsabmessungen des Zuführschachtes;

Fig. 4 eine perspektivische Ansicht der Vereinzelungseinrichtung;

Fig. 5 eine Ansicht der Prüfstation;

Fig. 6 eine Darstellung der Verteilerweiche;

Fig. 7 eine Darstellung der Ausgangsschächte und

Fig. 8 einen Schnitt gemäß Linie VIII-VIII aus Fig. 7.

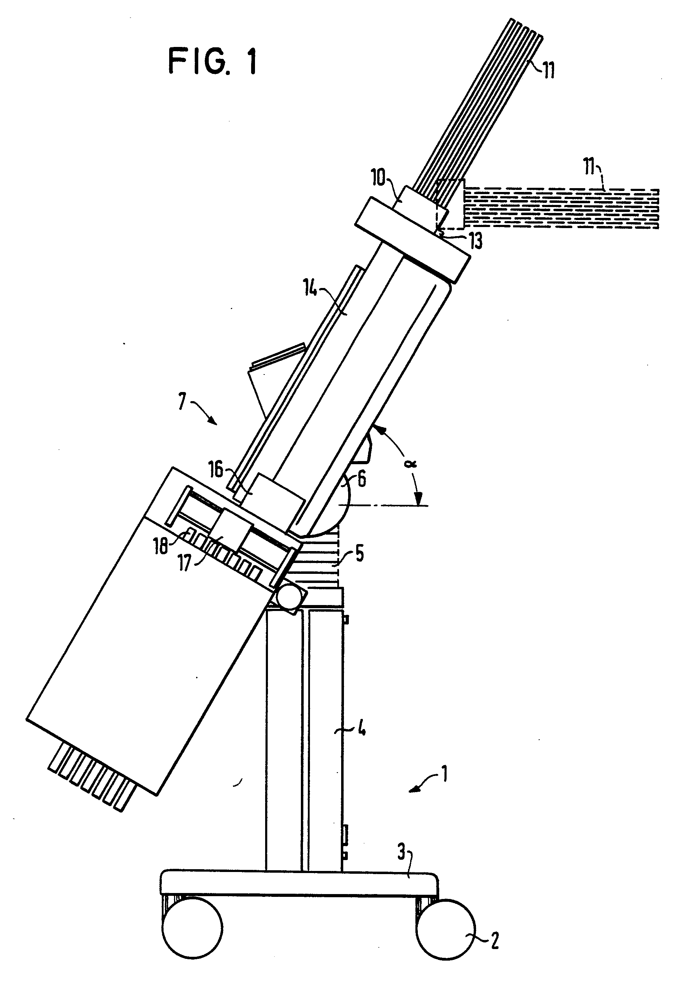

In Fig. 1 erkennt man ein Grundgestell 1 mit einer mit Rädern 2 versehenen Plattform 3 und einer von dieser nach oben ragenden Stütze 4, deren Länge teleskopartig veränderbar ist, wie der Faltenbalg 5 andeutet. Am oberen Ende der Stütze 4 befindet sich ein Einstellgelenk 6, über welches das insgesamt mit 7 bezeichnete Prüfgerät um einen Winkel $\alpha$ schwenkbar mit der Stütze verbunden ist. Die Einstellung des Winkels $\alpha$ richtet sich nach der Art der zu prüfenden Bauelemente: Für schwerere und empfindlichere Bauelemente wird $\alpha$ kleiner gewählt, damit sie nicht so schnell rutschen, für leichtere Bauelemente wird $\alpha$ größer gewählt.

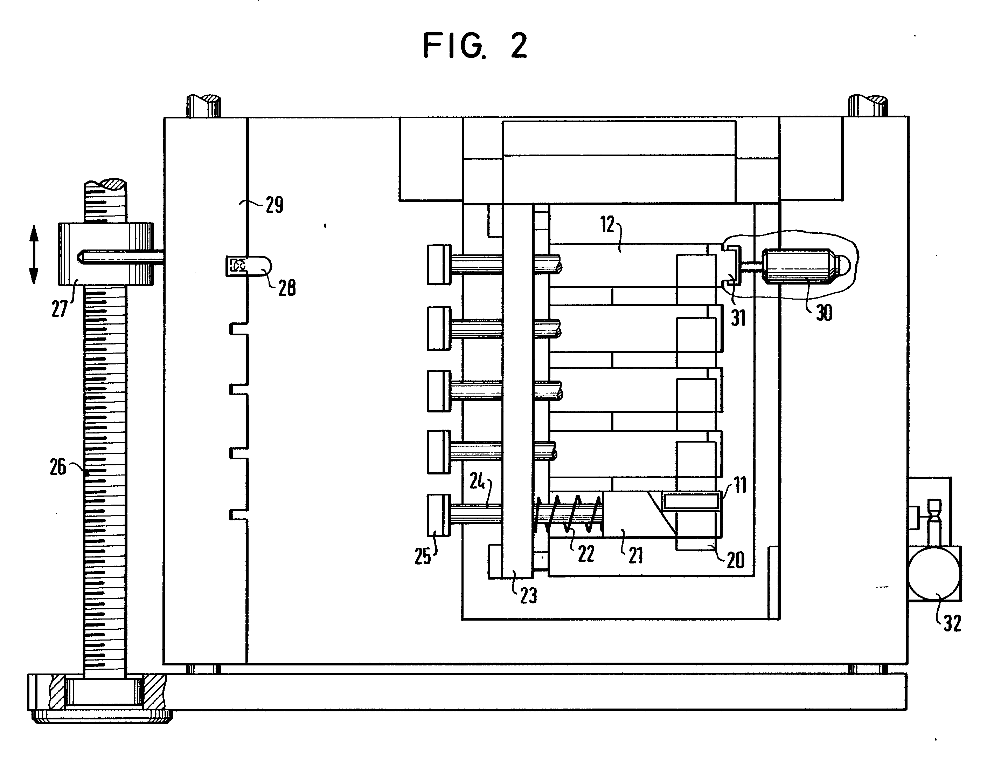

Am oberen Ende des Gerätes 7 befindet sich ein Magazinkopf 10 mit eingesteckten Magazinen 11. Die gestrichelt gezeichnete aufgeklappte Stellung ist die Beschickungsstellung, in welcher die Magazine 11 waagerecht in die Einstecköffnungen 12 (Fig. 2) des Magazinkopfes eingesteckt werden können, ohne daß die Bauelemente herausrutschen. Nach dem Einstecken der Magazine wird der Magazinkopf 10 über ein Gelenk 13 in die ausgezogen gezeichnete Lage geklappt, in welcher die Magazine in derselben Richtung wie die Zuführschacht 14 verlaufen, gegenüber dem der Magazinkopf 10 quer verschiebbar ist, so daß die einzelnen Magazine nacheinander mit dem Zuführschacht ausgerichtet werden können. Am anderen Ende des Zuführschachtes befindet sich eine Prüfstation 16, unterhalb deren ein Verteiler 17 angeordnet ist, um die fertig geprüften Bauelemente auf eine Anzahl Ausgangsschächte 18 zu verteilen. In der Zeichnung sind sieben Ausgabeschächte veranschaulicht, in welche die geprüften Bauelemente je nach Prüfergebnis gelangen. An die unteren Enden der Ausgabeschächte 18 lassen sich Ausgabemagazine zum Entleeren der Schächte anstecken, und in den Ausgabemagazinen befinden sich dann die nach Prüfungsergebnis sortierten Bauelemente.

Fig. 2 zeigt eine teilweise geschnittene Draufsicht auf den Magazinkopf 10. Man erkennt fünf mit ihren breiten Seiten nebeneinander angeordnete Einstecköffnungen 12 für Magazine 11, von denen eins in der untersten Einstecköffnung eingezeichnet ist. Es wird von einer Blattfeder 20 gegen die in der Zeichnung obere Wand der Einstecköffnung gedrückt, während ein keilförmiger Schieber 21, der durch eine Feder 22 nach rechts gedrückt wird, mit seiner Keilfläche das Magazin 11 gegen die schmale rechte Seite der Einstecköffnung drückt, so daß dies sicher im Magazinkopf gehalten wird. Am rückwärtigen Ende jedes Schiebers 21 befindet sich eine durch eine Führung 23 laufende Stange 24 mit einem Zuggriff 25, mit Hilfe dessen der Schieber zum Einsetzen eines Magazins gegen die Kraft der sich an der Führung 23 abstützenden Feder 22 zurückgezogen werden kann. Die, wie dargestellt, parallelen Einstecköffnungen, deren Anzahl nicht auf die gezeichneten fünf beschränkt ist, ergibt eine raumsparende Anordnung und zugleich eine günstige Konstruktion für den Ausrichtmechanismus zwischen den einzelnen Einstecköffnungen mit Magazinen und dem Zuführschacht.

Diese Einstellung erfolgt über einen motorisch angetriebenen umsteuerbaren Spindeltrieb mit einer Spindel 26 und einer Spindelmutter 27, mit Hilfe dessen der gesamte Magazinkopf gegenüber dem den Zuführschacht enthaltenden übrigen Teil des Gerätes verschiebbar ist. Zur exakten Ausrichtung der einzelnen Magazine mit dem Zuführschacht dient eine Lichtschrankenanordnung mit einer Lichtschranke 28, die mit einer zahnförmigen Blende 29 zuammenarbeitet, die den einzelnen Einstecköffnungen entsprechende Markierungen (Hell- oder Dunkelabschnitte) aufweist und in der exakten Ausrichtposition ein Stoppsignal für den Antriebsmotor des Spindeltriebes liefert.

Ferner erkennt man in Fig. 2 einen Elektromagneten 30, der oberhalb des Zuführschachtes angeordnet ist, und eine Haltezunge 31 betätigt, mit Hilfe deren die Bauelemente erst dann zur Überführung vom Magazin in den Zuführschacht freigegeben werden, wenn das betreffende Magazin mit dem Zuführschacht ausgerichtet ist. Die Bauelemente rutschen dann unter ihrem Eigengewicht mit einer Geschwindigkeit aus dem Magazin in den Zuführschacht, welche durch die Neigung der gesamten Linearstrecke gestimmt wird, die mit Hilfe des Einstellgelenkes 6 so eingestellt wird, daß die Bauelemente einerseits problemlos nachrutschen, andererseits aber nicht durch zu starke Stöße beschädigt werden können, was insbesondere bei Bauelementen mit Keramikgehäusen wichtig ist. Nach Entleerung eines Magazins wird der Magazinkopf 10 zur Ausrichtung des nächsten Magazins mit dem Zuführschacht mit Hilfe des erwähnten Spindeltriebes verfahren.

In Figur 2 erkennt man auch rechts einen Hebel 32, mit dem eine den Magazinkopf in der ausgezogen gezeichneten Betriebslage haltende Verriegelung gelöst werden kann, wenn der Kopf zum Einsetzen neuer Magazine in die gestrichelt dargestellte Beschickungslage umgeklappt werden soll.

Der Verstellmechanismus für den Zuführschacht 14 ist aus Fig. 3 ersichtlich. Man erkennt ferner ein im Zuführschacht 14 befindliches Bauelement 41, das mit seiner der Kontaktseite gegenüberliegenden Fläche auf einer Bezugswand 42 aufliegt und mit seiner rechten Unterkante an einer Bezugskante 43 anliegt, während seine linke Unterkante von einer Einstellkante 44 einer Anschlagschiene 45 geführt wird. Diese Anschlagschiene läßt sich in Pfeilrichtung zur Einstellung der Breite des Führungsschachtes 14 zwischen Bezugs-und Einstellkante verstellen. Die Höhe des Führungsschachtes wird bestimmt durch die in der Zeichnung nach unten ragende Führungskante 46 einer Führungsschiene 47 und eine parallel zur Führungskante 46 federnd gelagerte Leiste 48, die über die Länge des Führungsschachtes mittels mehrerer Bolzen 49 geführt und durch Federn 50 von der Führungskante 46 weggedrückt wird. Dabei sind die Abmessungen so gewählt, daß in der breitesten Einstellung des Führungskanals 14 die Leiste 48 das Bauelement 41 etwa in seiner Mitte führt, während in der schmalsten Einstellung die Leiste 48 an der Führungskante 46 anliegt (wobei die Feder 49 zusammengedrückt ist) und die beiden unteren Flächen von Führungskante 46 und Leiste 48 das Bauelement praktisch auf seiner gesamten Oberfläche zwischen den Kontakten führen. Wird die Anschlagschiene 45 von der breitesten Einstellung nach rechts zu schmaleren Einstellungen der Zuführschachtbreite verschoben, so legt sich die Leiste 48 bei einer mittleren Einstellung gegen Anschläge 51 und wird bei weiterer Verringerung der Zuführschachtbreite gegen die Kraft der Feder 49 auf die Führungskante 46 zu geschoben bis zur Anlage an dieser bei der schmalsten Zuführschachtbreite.

In Fig. 3 erkennt man ferner eine Grundplatte 60, gegenüber der ein insgesamt mit 61 bezeichneter Support mit Hilfe eines Spindeltriebes 62 in Pfeilrichtung verschiebbar gelagert ist. Mit Hilfe des Spindeltriebes 62 läßt sich die Breite des Zuführungsschachtes durch Verschiebung des gesamten Supports gegenüber der festen Bezugswand 42 (und den ebenfalls festen Anschlägen 51) verstellen. Der Spindeltrieb 62 ist über einen Zahnriementrieb 63 mit einem hier nicht veranschaulichten weiteren Spindeltrieb gekoppelt, und diese beiden Spindeltriebe sorgen zusammen mit ebenfalls nicht dargestellten Führungsbolzen für eine exakte Parallelführung der Anschlagschiene 45 mit ihrer Einstellkante 44 gegenüber der Bezugskante 43. Der Spindeltrieb 62 ist mit Hilfe eines Handrades 64 mit Mikrometerteilung 65 betätigbar, so daß die Breite des Zuführkanals auf Zehntelmillimeter genau einstellbar und ablesbar ist.

Der Support 61 trägt ferner einen weiteren Spindeltrieb mit einer Spindel 70, die über ein Handrad 71, ebenfalls mit Mikrometerteilung 72 verdrehbar ist und dabei die Führungsschiene 47 mit ihrer Führungskante 46 und der Leiste 48 in (in der Zeichnung) senkrechter Richtung verstellt. Auch dieser Spindeltrieb ist über einen Zahnriementrieb 73 mit weiteren, hier nicht dargestellten Spindeltrieben zur Parallelführung der Führungsschiene 47 gekoppelt.

Die Zeichnung läßt ferner eine auf der Grundplatte 60 angeordnete Isolierung 75 erkennen, auf der eine Heizfolie 76 angebracht ist, welche sich über die gesamte Länge des Führungsschachts erstreckt und auf dieser Länge eine Erwärmung der Bauelemente auf ca. 155°C bis zur Prüfstation erlaubt, um auch Fehler zu erfassen, die nur bei warmen Bauelementen auftreten.

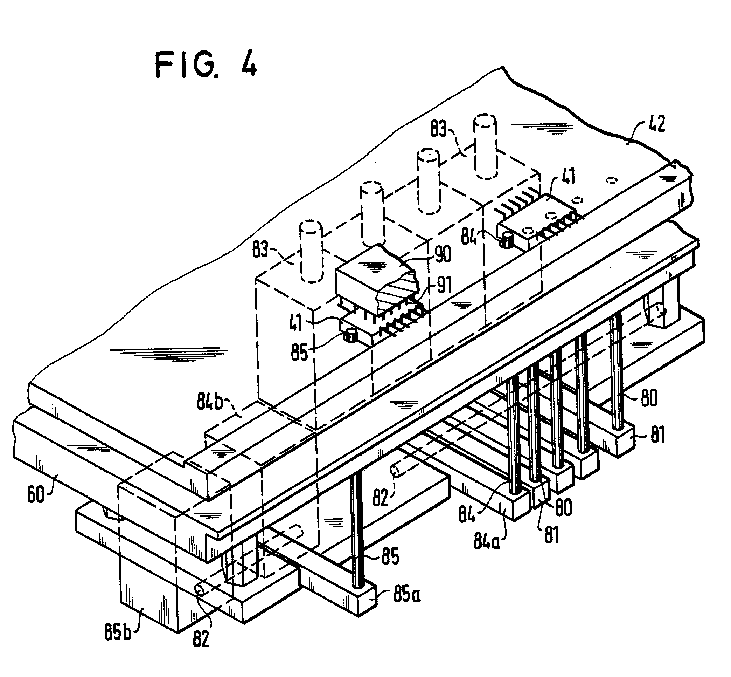

In der perspektivischen Ansicht der Vereinzelungsvorrichtung gemäß Fig. 4 erkennt man ein Bauelement 41, welches sich vom Ende des Zuführschachtes 14 einem von mehreren Haltestiften 80 nähert. Die Haltestifte 80 sind an ihren anderen Enden mit Kipphebeln 81 gekoppelt, die um eine gemeinsame Achse 82 schwenkbar gelagert sind. Jeder der Kipphebel läßt sich durch einen zugehörigen Kipphebelmagnet 83 betätigen, wobei er sich um die Achse 82 dreht und seinen Haltestift 80 nach oben drückt, so daß dieser ein gerade dort befindliches Bauelement an die von der oberen Schiene gebildete Gegenfläche drückt und das Bauelement festhält, so daß es nicht weiterrutschen kann. Auf diese Weise wird der ganze nachfolgende Stapel von Bauelementen ebenfalls festgehalten, wobei nur das bereits an der Vereinzelungsvorrichtung vorbeigelaufene Bauelement in die Prüfstation hineingleiten kann, sobald das zuvor geprüfte Bauelement diese verlassen hat. Hinter den Haltestiften 80 ist ein Stoppstift 84 angeordnet, der den Zugang zur Prüfstation blockiert, solange sich in dieser ein Bauelement befindet. Er wird ebenfalls über einen Kipphebel 84a und einen Magnet 84b betätigt. Ein weiterer Stoppstift 85 mit Kipphebel 85a und Magnet 85b hält das zu prüfende Bauelement 41 in der Prüfposition und gibt es nach der Prüfung zum Weiterrutschen in die Weiche des Verteilers frei.

Da die Haltestifte 80 und 84 enger beieinander liegen als die zugehörigen Betätigungsmagnete gepackt werden können, sind die die Ankerbewegung der Magnete auf die Stifte übertragenden Kipphebel zum Teil seitlich abgewinkelt.

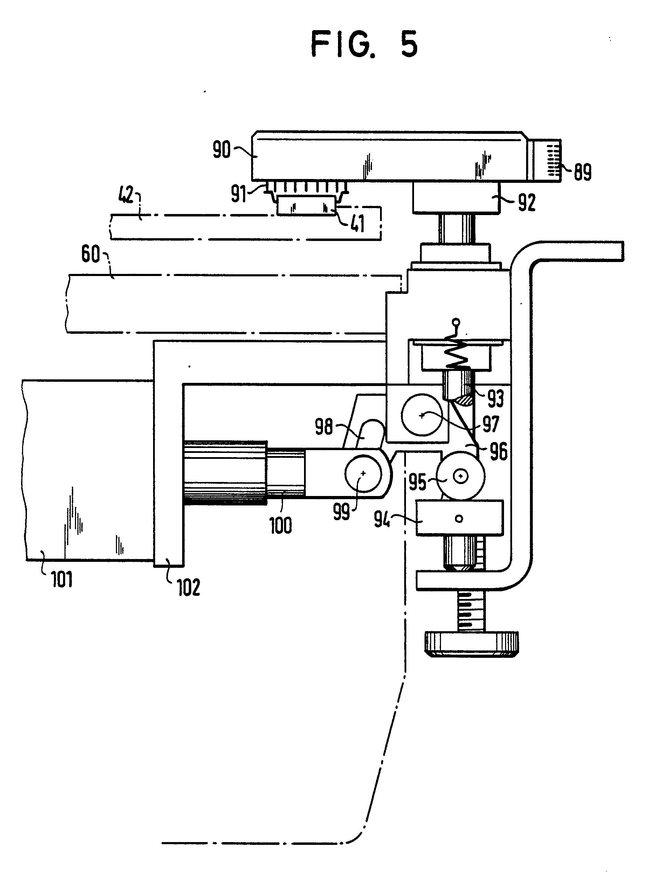

Fig. 5 läßt an der Prüfstation einen Meßkopf 90 erkennen, dessen Kontaktstife 91 sich auf die Kontakte des Bauelementes 41 mit einem vorbestimmten Kontaktdruck aufsetzen. Der Meßkopf 90 wird mit einem Meßkopfträger 92 verschraubt, beispielsweise mit zwei nicht veranschaulichten Schrauben, nach deren Lösen er gegen einen anderen Meßkopf für andere Bauelementtypen ausgetauscht werden kann. Der Meßkopfträger 92 sitzt an einer Zugstange 93, die an ihrem anderen Ende einen Mitnehmer 94 trägt. Gegen diesen Mitnehmer drückt eine Rolle 95, die an einem Ende eines Winkelhebels 96 sitzt, der seinerseits an einem Lagerpunkt 97 schwenkbar gelagert ist. Das andere Ende des Winkelhebels 96 ist mit einem Langloch 98 ausgebildet, in welchem ein Zapfen 99 am Anker 100 eines Zugmagneten 101 gleitet. Der Zugmagnet 101 ist an einem feststehenden Haltewinkel 102 befestigt. Erhält er Strom, dann zieht er seinen Anker 100 an, welcher den Winkelhebel 96 im Uhrzeigersinn um den Lagerpunkt 97 dreht, so daß die Rolle 95 den Mitnehmer 94 nach unten drückt, der die Zugstange 95 mit dem Meßkopfträger 92 mit nach unten nimmt, wobei der mit dem Meßkopfträger 92 verschraubte Meßkopf 90 ebenfalls nach unten gedrückt wird und sich mit seinen Kontaktstiften 91 auf die Kontakte des Bauelementes 41 aufsetzt. Über den Erregerstrom des Zugmagneten 101 läßt sich die Zugkraft und damit die Andruckkraft zwischen den Kontaktstiften 91 und den Kontakten des Bauelementes so einstellen, so daß die Einzelkontaktkräfte bei nur wenigen Kontakten ebenso wie bei einer großen Kontaktzahl immer innerhalb eines gewünschten Bereiches liegen. Die Wahl der Erregerstromstärke richtet sich also nach der Anzahl der Kontakte des zu prüfenden Bauelementes und wird durch das jeweilige Prüfprogramm vorgegeben, das auch die übrigen Steuerungsabläufe und die diversen elektrischen Prüfungen durch Mikroprozessorsteuerung bestimmt.

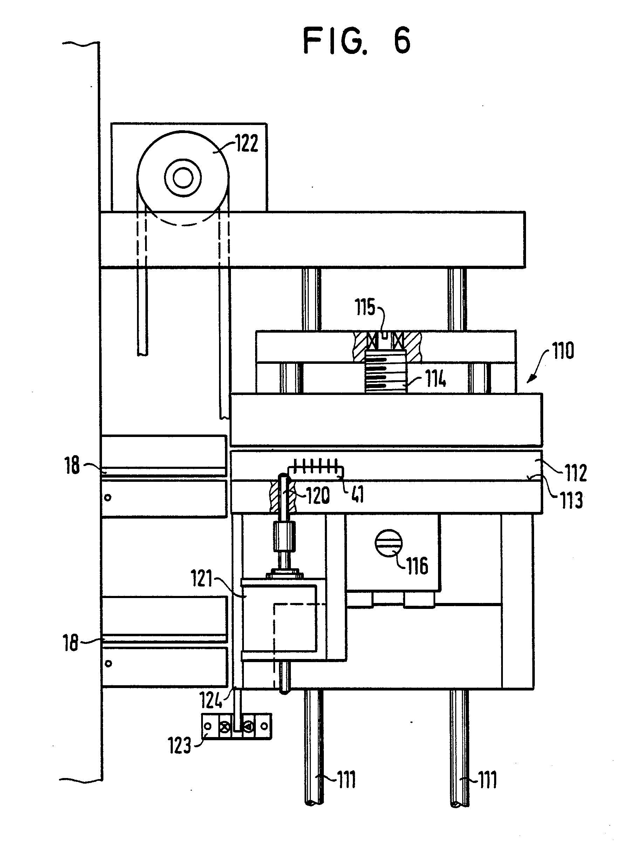

Die in Fig. 6 veranschaulichte Verteilerweiche läßt einen verstellbaren Schlitten 110 erkennen, der auf zwei Schienen 111 geführt ist und einen Kanal 112 aufweist, in dem ein Bauelement 41 veranschaulicht ist, welches von der Prüfstation kommt, die man sich in Fig. 6 auf der rechten Seite vorzustellen hat. Der Kanal 112 ist ebenso aufgebaut wie der in Fig. 3 veranschaulichte Zuführschacht. Auf seiner Bezugswand 113 liegt das Bauelement 14 mit der seinen Kontakten abgewandten Oberfläche auf. Der Bezugswand gegenüber befindet sich wiederum eine hier nicht nochmals veranschaulichte Führungskante mit gegenüber dieser federnd gelagerter Leiste entsprechend den Elementen 46 und 48 in Fig. 3. Die Kanalhöheneinstellung erfolgt mit Hilfe eines Spindeltriebes 114, mit der Hilfe einer Einstellschraube 115 verstellbar ist. Die Kanalbreiteneinstellung erfolgt über einen hierzu senkrechten weiteren Spindeltrieb, von dem nur die Einstellschraube 116 veranschaulicht ist. Auch hier sind eine Bezugskante und eine Einstellkante entsprechend den Elementen 43 und 44 in Fig. 3 vorgesehen, deren Abstand mit Hilfe der Einstellschraube 116 auf die jeweilige Breite der Bauelemente 41 einstellbar ist.

Fig. 6 läßt ferner einen Anschlagstift 120 erkennen, der in die Bahn des Bauelementes 41 ragt und mit Hilfe eines Elektromagneten 121 zurückgezogen werden kann, so daß das Bauelement 41 in den gerade beim Kanal 112 befindlichen Ausgabeschacht 18 rutschen kann. Der Schlitten 110 wird mit Hilfe eines Antriebs 122 längs seiner Schienen 111 bewegt, um seinen Kanal 112 zum jeweils gewünschten Ausgangsschacht zu fahren. Die genaue Ausrichtung erfolgt dabei mit Hilfe einer Lichtschranke 123, von der im dargestellten Ausführungsbeispiel die eine bei jedem Ausgangsschacht vorgesehen ist und mit einer am Schlitten vorgesehen Schaltkante 124 zusammenarbeitet.

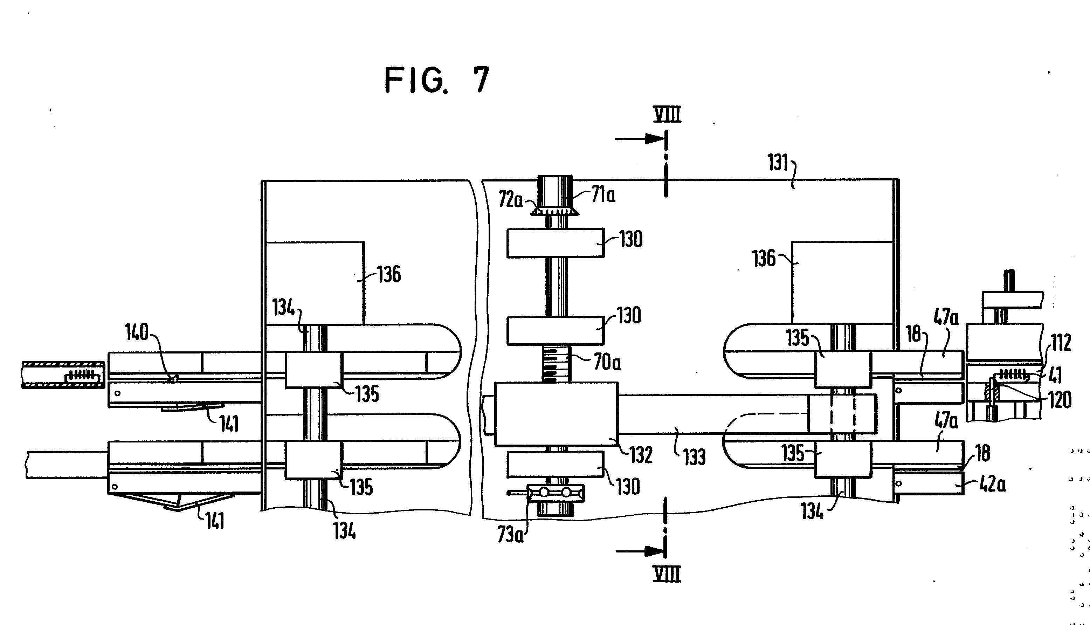

Nach genauer Ausrichtung des Kanals 112 mit einem Ausgabeschacht 18 gibt der Elektromagnet 121 über den Anschlagstift 120 den Weg für das Bauelement 41 frei, und dieses gleitet in den Schacht 18 hinein, wie Fig. 7 veranschaulicht. Die Ausgabeschächte 18 sind raumsparend übereinander angeordnet, also mit parallelen Querschnittslängsseiten, wie dies auch beim Magazinkopf gemäß Fig. 2 der Fall ist. Ferner sind die Kanäle 18 in gleicher Weise auf die Abmessungen der Bauelemente einstellbar, wie es Fig. 3 für den Zuführschacht 40 darstellt. Über ein Handrad 71a mit einer Mikrometereinteilung 72a läßt sich eine Spindel 70a verstellen, die in Lagerböcken 130 gelagert ist, die an einer Platte 131 befestigt sind. Von einer Spindelmutter 132 ragen zwei Arme 133 seitwärts weg, die an ihren Enden jeweils eine Stange 134 halten. Auf diesen Stangen sind Klötze 135 befestigt, an denen wiederum die Führungsschienen 47a der Ausgangsschächte befestigt sind und von ihnen zur Einstellung der Höhe der Ausgangsschächte mitgenommen werden, wenn das Handrad 71a gedreht wird. Dabei bewegt sich die Spindelmuttel 132 in der Zeichnung gemäß Fig. 7 nach oben bzw. unten und verschiebt über ihre Arme 133 die mit ihren beiderseitigen Enden in Linearlagern 136 gelagerten Stangen 134, mit denen sich auch die Klötze 135 nach oben bzw. unten verschieben und dabei die Führungsschienen 47a von den zugehörigen Bezugswänden 42a entfernen bzw. ihnen nähern.

Am unteren Ende der Spindel 70a erkennt man einen Zahnriementrieb 73a, mit Hilfe dessen eine hier nicht dargestellte weitere Spindel synchron angetrieben wird, die parallel zur Spindel 70a arbeitet, um über die Länge der Ausgangsschächte eine exakte Parallelführung der Führungsschienen zu gewährleisten.

Am linken Teil der Fig. 7 erkennt man die Enden der Ausgangsschächte, in denen jeweils ein Anschlag 140 angeordnet ist, der von einer Blattfeder 141 gehalten wird, welche ihn in den Schacht hineindrückt, so daß er die vom Verteiler kommenden Bauelemente 41 festhält, damit sie nicht hinausfallen. Soll ein Ausgangsschacht geleert werden, so wird in der Zeichnung von links ein Magazin in das Ende des Schachtes hineingesteckt und drückt dabei mit seiner Vorderkante gegen die Schrägfläche des Anschlags 140, so daß dieser gegen die Kraft zu einer Feder 141 beiseite gedrückt wird und die angesammelten Bauelemente 41 freigibt, die dann in das Magazin hineinrutschen. Beim Herausziehen des gefüllten Magazins drückt die Feder 141 den Anschlag 140 wieder zurück in den Ausgangsschacht, so daß diese am Ausgangsende wieder gesichert ist.

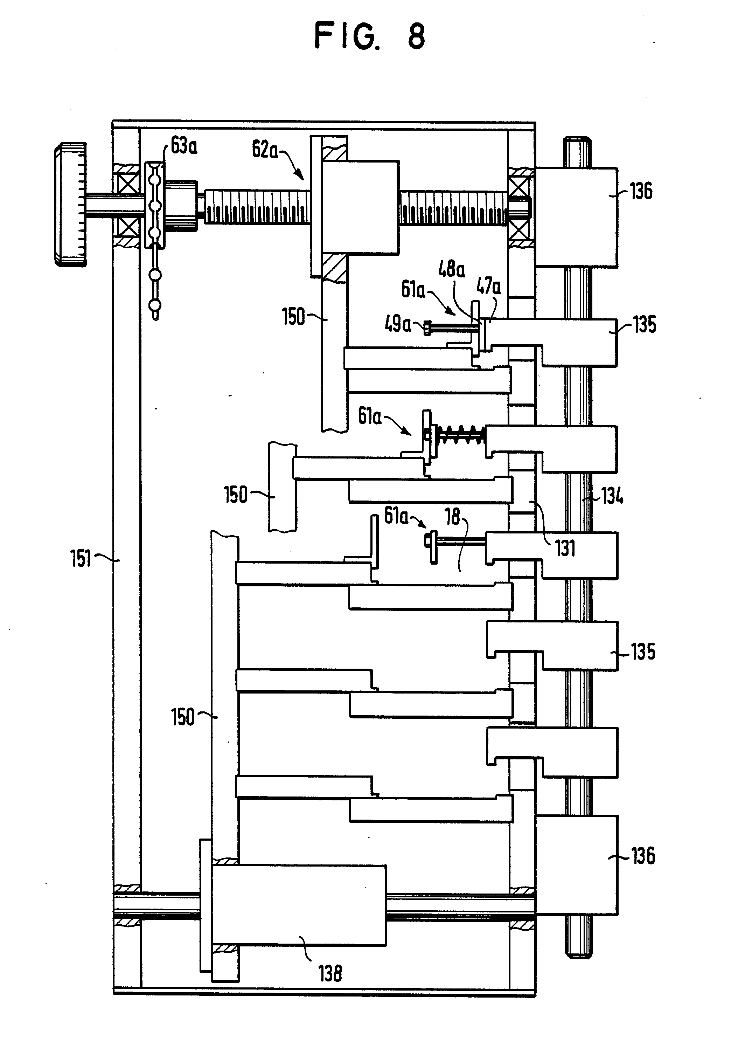

Fig. 8 zeigt eine Schnittansicht durch die Ausgangsschächte, welche deren Anordnung mit zueinander parallelen langen Querschnittsseiten und den gemeinsamen Einstellmechanismus für Höhe und Breite der Ausgangsschächte erkennen läßt. Die mit der Stange 134 verbundenen Klötze 135 tragen die Führungsschienen 47a mit den Bolzen 49a und den Leisten 48a, die für sämtliche Ausgangsschächte gleichsinnig nach oben oder unten verstellt werden.

Die Einstellung der Breite der Ausgangsschächte erfolgt über einen zweiten Spindeltrieb 62a, der über einen Zahnriementrieb 63a mit weiteren gleichartigen Spindeltrieben zur Parallelführung der Supporte 61a gekoppelt ist. Außerdem erkennt man unten in der Figur eins von mehreren Linearlagern 138, mit denen die Platte 150 parallel zur Platte 131 geführt wird. Ferner sieht man die beiderseitige Lagerung der Spindeln in den festen Platten 131 und 151, zwischen denen sich die Ausgangsschächte 18 und deren Einstellmechanismus befinden.

In Fig. 8 sind drei verschiedene Stellungen der Führungsplatte 150 für die Supporte 61a gezeichnet: Oben für die schmalste Ausgangsschachtbreite, darunter für eine mittlere Breite und unten für die größte Breite der Ausgangsschächte.

**Ansprüche**

1) Transportsystem für eine Prüfeinrichtung für elektronische Bauelemente
-mit einem Magazinkopf, über den die zu prüfenden Bauelemente aus mindestens einem Magazin in einen Zuführschacht gelangen,
-mit einer sich an den Zuführschacht anschließenden Prüfstation, an der ein auswechselbarer Prüfkopf jeweils ein Bauelement kontaktiert und durchprüft,
-und mit einem Verteiler, über den die geprüften Bauelemente je nach Prüfergebnis in verschiedene Ausgangsschächte überführt werden,
**dadurch gekennzeichnet,**
daß der vom Zuführschacht (14) wegklappbare Magazinkopf (10) mehrere auf unterschiedliche Magazinabmessungen einstellbare Einstecköffnungen (12) aufweist und gegenüber dem Zuführschacht derart verschiebbar gelagert ist, daß die eingesteckten Magazine (14) einzeln mit dem Zuführschacht ausrichtbar sind,
daß der Zuführschacht (14) mittels verstellbarer Schienen (45,47) in Höhe und Breite seines Querschnitts auf Bauelemente (41) unterschiedlicher Abmessungen einstellbar ist,
daß der Verteiler (17) eine auf die unterschiedlichen Bauelementabmessungen einstellbare Weiche (Schlitten 110) aufweist und die Ausgangsschächte (18) mit ihren Ausgangsöffnungen zum Einstecken der Magazine ebenfalls einstellbar sind,
daß die Transportstrecke für die Bauelemente vom Eingabemagazin bis zur Weiche geradlinig und anschließend parallel versetzt verläuft,
und daß die ganze Prüfeinrichtung zur Verstellung der Neigung dieser Geraden über ein Einstellgelenk (6) mit einem Grundgestell (1) verbunden ist.

2) Transportsystem nach Anspruch 1, dadurch gekennzeichnet, daß die Einstecköffnungen (12) für die im Querschnitt rechteckigen Magazine (11) mit nebeneinanderliegenden Querschnittslängsseiten parallel zueinander im Magazinkopf (10) angeordnet sind.

3) Transportsystem nach Anspruch 1 oder 2, dadurch gekennzeichnet, daß an einer Querschnittslängsseite jeder Einstecköffnung (12) eine Blattfeder (20) derart angeordnet ist, daß ein eingestecktes Magazine (11) gegen die andere Längsseite gedrückt wird.

4) Transportsystem nach Anspruch 1, 2 oder 3, dadurch gekennzeichnet, daß im Magazinkopf (10) für jede Einstecköffnung (12) ein in deren Querschnittslängsrichtung beweglicher Schieber (21) zum Andrücken eines eingesteckten Magazins (11) an die gegenüberliegende Querschnittsschmalseite federnd gelagert ist.

5) Transportsystem nach Anspruch 3 und 4, dadurch gekennzeichnet, daß die Andruckfläche des Schiebers (21) keilförmig zum Andrücken des Magazins an die der Blattfeder (20) gegenüberliegenden Seite der Einstecköffnung abgeschrägt ist und daß jeder Schieber an seinem rückwärtigen Ende mit einem Zuggriff (25) zur Freigabe der Einstecköffnung versehen ist und die Zuggriffe aller Schieber in einer Reihe liegen.

6) Transportsystem nach Anspruch 1 oder 2, dadurch gekennzeichnet, daß an jeder Einstecköffnung (12) eine elektromagnetisch betätigbare .Haltezunge (31) als Anschlag für die aus einem Magazin (11) in den Zuführschacht (14) zu überführenden Bauelemente (41) vorgesehen ist.

7) Transportsystem nach Anspruch 1 oder 2, dadurch gekennzeichnet, daß zur Verschiebung des Magazinkopfes (10) ein motorischer Spindelantrieb (26,27) und zur Ausrichtung der Magazine mit dem Zuführschacht (14) eine mit einer entsprechend unterteilten Blende (29) zusammenwirkende Lichtschranke (28) vorgesehen ist.

8) Transportsystem nach Anspruch 1, dadurch gekennzeichnet, daß der Zuführschacht (14) eine feste Bezugswand und als deren Begrenzungen eine feste Bezugskante (43) und eine dieser gegenüberliegende Einstellkante (44) einer der Schienen (Einstellschiene 45) sowie eine von der anderen Schiene (Führungsschiene 47) gebildete Gegenfläche aufweist, die in zwei Teilflächen (46,48) mit veränderbarem gegenseitigen Abstand unterteilt ist.

9) Transportsystem nach Anspruch 8, dadurch gekennzeichnet, daß die eine Teilfläche von einer abgewinkelten Kante (Führungskante 46) der einen Schiene (Führungsschiene 47) gebildet wird und die andere Teilfläche von einer parallel zu dieser Kante geführten und federnd gegen sie gelagerten Leiste (48) gleicher Länge gebildet wird, die gegen mit der festen Bezugswand verbundene Anschläge (51) anstößt.

10) Transportsystem nach Anspruch 8, dadurch gekennzeichnet, daß die Bezugswand mit der Bezugskante (43) an einem Tragkörper (Grundplatte 60) befestigt ist, auf dem ein Support (61) über einen Spindeltrieb (62) verschiebbar ist, und daß die die Einstellkante (44) bildende Schiene (Anschlagschiene 45) fest mit dem Support verbunden ist und auf diesem seinerseits ein weiterer Spindeltrieb (70) für die andere Schiene (Führungsschiene 47) angeordnet ist.

11) Transportsystem nach Anspruch 8 oder 10, dadurch gekennzeichnet, daß für jede Schiene mehrere, von einem Einstellrad (64) über Zahnriemen (63) oder Ketten synchron betätigte Spindeltriebe vorgesehen sind.

12) Transportsystem nach Anspruch 1, dadurch gekennzeichnet, daß zwischen dem Zuführschacht (14) und der Prüfstation eine Vereinzelungsvorrichtung angeordnet ist, die eine Reihe magnetbetätigter Haltestifte (80) in auf die unterschiedlichen Bauelementlängen abgestimmter Anordnung enthält (Fig. 4).

13) Transportsystem nach Anspruch 1, dadurch gekennzeichnet, daß in der Prüfstation ein Testkopfhalter (92), ein Winkelhebel (96) zu dessen Verschiebung in Prüf-bzw. Ruhestellung und ein Antriebsmagnet (101) für den Winkelhebel angeordnet sind und daß ein Einsteller für den Magnetstrom zur Wahl der Andruckkraft der Testkopfkontakte (91) gegen die Kontakte des Bauelementes (41) vorgesehen ist.

14) Transportsystem nach Anspruch 1, dadurch gekennzeichnet, daß für einen Steckeranschluß der auswechselbaren Testköpfe eine Kontaktleiste (89) fest angeordnet ist, gegen die eine Meßeinheit fahrbar ist.

15) Transportsystem nach Anspruch 1, dadurch gekennzeichnet, daß der Zuführschacht und die Prüfstation mit einer Heizvorrichtung (Heizfolie 76) versehen sind.

16) Transportsystem nach Anspruch 15, dadurch gekennzeichnet, daß die Heizvorrichtung als längs der die Bezugswand bildenden breiten Auflagefläche des Kanals angeordnete Heizfolie (76) ausgebildet ist.

17) Transportsystem nach Anspruch 1, dadurch gekennzeichnet, daß die Weiche einen verstellbaren Schlitten (110) mit einem mit der Prüfstation bzw. den einzelnen Ausgangsschächten (18) ausrichtbaren Kanal (112) zur Aufnahme eines geprüften Bauelementes (41) aufweist, der in gleicher Weise wie der Zuführkanal in seinem Querschnitt einstellbar ist.

18) Transportsystem nach Anspruch 17, dadurch gekennzeichnet, daß zur Definierung der einzelnen Stellungen der Weiche eine Lichtschranken-Blenden-Anordnung (123, 124) vorgesehen ist.

19) Transportsystem nach Anspruch 1, dadurch gekennzeichnet, daß die Bauelementauflagefläche in der Prüfstation und in der Weiche mit Rillen ausgebildet ist.

20) Transportsystem nach Anspruch 1, dadurch gekennzeichnet, daß die Ausgangsschächte (18) in ihren Querschnittsabmessungen ebenfalls mittels über gekoppelte Spindeltriebe (62a, 70a) verstellbarer Schienen auf die Abmessungen der Bauelemente einstellbar sind.

21) Transportsystem nach Anspruch 1, dadurch gekennzeichnet, daß die Ausgangsschächte mit parallel nebeneinanderliegenden Bezugswänden angeordnet sind.

22) Transportsystem nach Anspruch 1 oder 20, dadurch gekennzeichnet, daß die Ausgangsschächte (18) an ihren Ausgabeenden Einschuböffnungen für Magazine und in deren Bereich angeordnete federnde Anschläge (140) für im Ausgangsschacht befindliche Baulemente aufweisen, die beim Einstecken eines Magazins zur Freigabe der Bauelemente wegdrückbar sind.

# FIG. 1

# FIG. 2

# FIG. 3

FIG. 4

# FIG. 5

# FIG. 6

# FIG. 7

VIII

72a — 71a

131

130

130

70a

136

134

140

135

141

134

136

135

18 47a

135

18

112

41

120

47a

42a

132    133    135

73a    134

VIII

0 253 015

# FIG. 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 588 092 (MOECHNIG et al.) <br><br> * Insgesamt * <br><br> --- | 1,2,6, 8,10, 15,17, 20,21 | B 07 C 5/344 <br> G 01 R 31/28 |
| A | EP-A-0 166 409 (TAKEDA RIKEN) <br><br> * Figuren 1-7; Seite 6, Zeile 28 - Seite 13, Zeile 20 * <br><br> --- | 1,2,12 ,15 | |
| A | US-A-3 727 757 (BOISSICAT) <br> * Figuren 1-11; Spalte 2, Zeile 43 - Spalte 7, Zeile 28 * <br><br> ----- | 1,12 | |

RECHERCHIERTE SACHGEBIETE (Int. Cl.4)

B 07 C
G 01 R

Der vorliegende Recherchenbericht wurde für alle Patentansprüche erstellt.

| Recherchenort | Abschlußdatum der Recherche | Prüfer |
|---|---|---|
| DEN HAAG | 24-03-1987 | GYSEN L.A.D. |